# EUROPÄISCHE PATENTANMELDUNG

(11) **EP 0 948 103 A2**
(43) Veröffentlichungstag der Anmeldung: **06.10.1999**
(21) Anmeldenummer: 99106347.0
(22) Anmeldetag: 27.03.1999
(51) Int. Cl.: H01R 23/72

(54) **Befestigungsanordnung eines Steckverbinders an einer Leiterplatte**

(30) Priorität: 28.03.1998 DE 19813932
(71) Anmelder: WÜRTH ELEKTRONIK GmbH & Co. KG, D-74676 Niedernhall (DE)
(72) Erfinder: Gross, Karl-Heinz, 74747 Ravenstein-Unterwittstadt (DE)
(74) Vertreter: Patentanwälte Ruff, Beier, Schöndorf und Mütschele

(57) **Zusammenfassung**

Es wird eine Leiterplatte mit einem oder mehreren Steckverbindern und ein Verfahren zum Anbringen von Steckverbindern an der Leiterplatte vorgeschlagen, bei dem der Steckverbinder ein stumpfes der Leiterplatte zugeordnetes Ende aufweist. Dieses Ende wird flächig mit einem Landepad verlötet oder verpreßt. Dadurch lassen sich robuste Anbringungen von Steckverbindern herstellen.

## Beschreibung

Die Erfindung geht aus von Steckverbindern, die an Leiterplatten angebracht sind. Steckverbinder dienen dazu, periphere Bauteile zu befestigen, beispielsweise Kabelstecker, Tochterkarten oder dergleichen. Bislang ist es bekannt, solche Steckverbindern in durchkontaktierte Bohrungen der Leiterplatte einzupressen oder in SMT aufzulöten.

Der Erfindung liegt die Aufgabe zugrunde, eine Möglichkeit der Anbringung von Steckverbindern zu schaffen, die einfach durchgeführt werden kann und zu einer robusten Gehäusetechnologie führt.

Zur Lösung dieser Aufgabe schlägt die Erfindung eine Befestigungsanordnung bzw. eine Leiterplatte mit den Merkmalen des Anspruchs 1 sowie ein Verfahren mit den im Anspruch 11 genannten Merkmalen vor. Weiterbildungen der Erfindung sind Gegenstand der abhängigen Ansprüche, deren Wortlaut ebenso wie der Wortlaut der Zuammenfassung durch Bezugnahme zum Inhalt der Beschreibung gemacht wird.

Nach der Erfindung ist es also nicht mehr erforderlich, ein Loch zu bohren und zu kontaktieren. Vielmehr wird die Leiterplatte an der Stelle, an der der Steckverbinder angebracht werden soll, mit einer metallischen Beschichtung versehen, beispielsweise einem Lötpad. Hieran wird der Steckverbinder elektrisch leitend angebracht. Da keine Löcher vorhanden sind, können die Steckverbinder auch näher aneinander herangerückt werden. Die Anbringung der Steckverbinder läßt sich in stärkerem Maße automatisieren.

Erfindungsgemäß kann in Weiterbildung vorgesehen sein, daß das stumpfe Ende des Steckverbinders mindestens in seinem Randbereich in einer Ebene liegt, die senkrecht zu der Längsachse des Steckverbinders verläuft. Es steht auf diese Weise eine relativ große Fläche zur Verfügung, an der die Befestigung und/oder die elektrisch leitende Verbindung erfolgen kann. In Einzelfällen ist es natürlich auch denkbar, daß das stumpfe Ende des Steckverbinders zwar in einer Ebene liegt, die aber nicht senkrecht zur Längsachse des Steckverbinders verläuft, wenn nämlich der Steckverbinder schräg zur Leiterplatte verlaufen soll.

Die Art der Verbindung oder Befestigung des Steckverbinders mit der Leiterplatte kann auf verschiedene Arten erfolgen. Es können sowohl Befestigungsarten verwendet werden, die gleichzeitig eine mechanische und elektrische Verbindung bilden, als auch Befestigungsarten, bei denen die Befestigung und die elektrisch leitende Verbindung auf getrennte Weise erfolgen.

Beispielsweise schlägt die Erfindung vor, das stumpfe Ende des Steckverbinders mit der Fläche zu verlöten.

Zur Verlötung kann vorgesehen sein, auf die metallische Fläche der Leiterplatte und/oder das Ende des Steckverbinders eine Lötmasse, beispielsweise eine Lötpaste, aufzubringen und anschließend die beiden Teile miteinander in Kontakt zu bringen und die Verlötung durchzuführen.

In Weiterbildung der Erfindung kann vorgesehen sein, das Ende des Steckverbinders konkav auszubilden, beispielsweise in Form einer Vertiefung. Die Vertiefung kann von den Rändern der Endfläche des Steckverbinders einen Abstand aufweisen. In die Höhlung des konkaven Endes des Steckverbinders kann Lötpaste oder aber insbesondere eine Lötkugel eingebracht werden. Dies gilt insbesondere für die Vertiefung, die so ausgebildet werden kann, daR sie der Form einer Lötkugel einigermaßen entspricht. Die Befestigung von elektronischen Bauteilen mit einer Vielzahl von Lötkugeln ist an sich bekannt. Dort werden aber sehr viele Lötkugeln zur Anbringung eines Bauteils verwendet, das eine große parallel zu der Leiterplatte verlaufende Fläche aufweist, so daß sich die Kräfte über eine große Fläche verteilen.

Auch eine Ausbildung des Steckverbinders als Rohr oder mit einer Sacklochbohrung in seinem stumpfen Ende ist möglich.

Es kann ebenfalls und ggf. auch zusätzlich vorgesehen sein, die Leiterplatte mit einer Vertiefung zu versehen, die entweder zur Aufnahme einer Lötkugel dienen kann oder dazu, eine Ausrichtung des Steckverbinders durchzuführen, wenn dieser in seinem Ende eine Lötkugel aufweist.

Zur Verbesserung und Vergrößerung der mechanischen Festigkeit kann erfindungsgemäß vorgesehen werden, daß das Ende des Steckverbinders eine vergrößerte Fläche aufweist, beispielsweise mindestens zu einer oder zwei gegenüberliegenden Seiten hin. Dann kann die Verlötung oder die Verbindung über eine größere Fläche erfolgen. Eine mögliche Form ist ein Pyramidenstumpf, der an dem Ende des Steckverbinders angeordnet ist. Ebenfalls möglich ist eine Quaderform, eine T-Form oder eine Zylinderform.

Eine andere Art der Verbindung des Steckverbinders mit der metallischen Fläche ist eine Verpressung, bei der beispielsweise die mechanische Verbindung durch Schrauben, Nieten oder dgl. erfolgt, während die elektrisch leitende Verbindung ein einfacher mechanischer Kontakt ist. Hier kann vorgesehen sein, an dem stumpfen Ende des Steckverbinders ein Federelement mit einer großen Fläche anzubringen oder auch ein Element aus SMA-Material, damit die elektrisch leitende Verbindung auch dann aufrechterhalten wird, wenn sich die mechanische Verbindung etwas lockert.

Das von der Erfindung vorgeschlagene Verfahren sieht so aus, daß die Leiterplatte mit der metallischen Beschichtung versehen wird, daß ein Steckverbinder mit einem stumpfen Ende verwendet wird, und daß das stumpfe Ende des Steckverbinders mit der metallischen Fläche in Kontakt gebracht und leitend mit dieser verbunden wird.

Erfindungsgemäß kann eine Verlötung und/oder eine Verpressung zwischen den metallisch leitendem Teilen erfolgen.

Weitere Merkmale, Einzelheiten und Vorzüge der Erfindung ergeben sich aus der folgenden Beschreibung einer bevorzugten Ausführungsform der Erfindung sowie anhand der Zeichnung. Hierbei zeigen:
- Fig. 1: einen schematischen Schnitt durch eine Leiterplatte mit einem Steckverbinder vor Herstellung einer Verbindung;
- Fig. 2: einen ähnlichen Schnitt bei einer geänderten Ausführungsform;
- Fig. 3: perspektivisch das Ende eines Steckverbinders;
- Fig. 4: eine Seitenansicht des Endes eines Steckverbinders bei einer weiteren Ausführungsform;
- Fig. 5: schematisch die Anbringung eines Steckverbinders mit Hilfe einer mechanischen Verpressung.

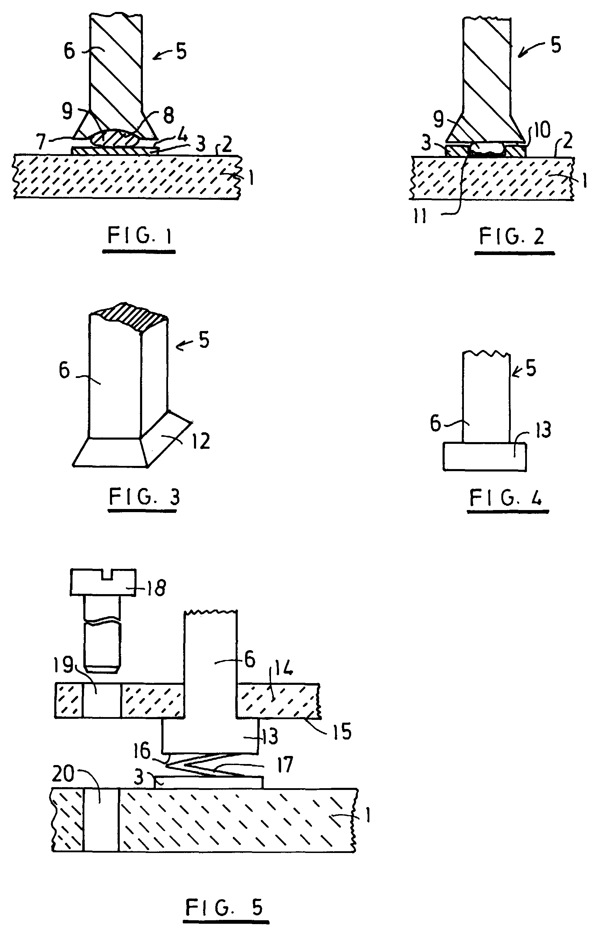

In der sehr vereinfachten Darstellung der Fig. 1 ist eine Leiterplatte 1 im Schnitt zu sehen. Die Leiterplatte 1 ist auf ihrer einen Seite, in Fig. 1 der Oberseite 2, mit einer metallischen Beschichtung zur Bildung von Leiterbahnen oder dergleichen versehen. An einer bestimmten Stelle, die gerade in Fig. 1 dargestellt ist, bildet die metallische Beschichtung ein Lötpad 3, also eine Stelle, an der eine metallische Oberfläche 4 vorhanden ist. Mit diesem Lötpad soll ein Steckverbinder 5 verbunden werden. Dieser Steckverbinder 5 enthält einen abgebrochen dargestellten Schaft 6 mit einem stumpfen Ende 7, das der Leiterplatte 1 zugeordnet ist. In dem stumpfen Ende 7 ist eine Vertiefung 8 eingeformt. Das Ende des Steckverbinders weist eine vergrößerte Fläche auf, die dadurch entsteht, daß sich der Querschnitt des Steckverbinders zu der Endfläche 7 hin verbreitert. Die Vertiefung ist so ausgebildet, daß sie nicht bis zu dem Rand der Endfläche 7 reicht, sondern von einem ebenen Bereich umgeben ist.

In der Vertiefung 8 ist eine Lötkugel 9 angeordnet, die an dem Steckverbinder 5 zunächst haftet. Der Steckverbinder 5 wird mit der Lötkugel 9 dem Lötpad 3 angenähert und vorübergehend fixiert. Anschließend erfolgt die Verlötung in der üblichen Weise. Bei der Erhitzung wird die Lötkugel 9 flüssig und bildet eine schmale Flüssigkeitsschicht, die die Fläche zwischen dem Lötpad 3 und dem stumpfe Ende 7 vollständig benetzt. Nach dem Erkalten und Aushärten ist der Steckverbinder 5 daher an dem Lötpad 3 festgelegt, sowohl in mechanischer als auch in elektrischer Hinsicht.

In Fig. 2, die ebenfalls schematisch zu verstehen ist, ist die Stirnfläche 10 des stumpfen Endes des Steckverbinders 5 eben ohne Vertiefung ausgebildet, während in dem Lötpad 3 eine Vertiefung 11 angeordnet ist. Die Vertiefung 11 reicht nicht bis ganz zu der Oberseite 2 der Leiterplatte. In der Vertiefung 11 ist eine Lötkugel 9 angeordnet. Die Verlötung geschieht in der gleichen Weise wie bei Fig. 1 beschrieben. Es ist natürlich auch möglich, die Vertiefung 11 für die Lötkugel 9 auch bis unter die Oberfläche 2 der Leiterplatte 1 reichen zu lassen.

Auch eine Kombination der Befestigungsmethoden der Fig. 1 und 2 ist möglich, nämlich eine Vertiefung sowohl in dem Steckverbinder als auch in dem Lötpad anzuordnen.

Die Fig. 3 zeigt eine Möglichkeit, wie das stumpfe Ende 7 eines Steckverbinders ausgestaltet sein kann. Der Steckverbinder 5 hat einen Schaft 6 mit einem rechteckigen Querschnitt. Dieser Querschnitt vergrößert sich am stumpfen Ende 7 nach allen Seiten, so daß eine Art Pyramidenstumpf 12 gebildet wird. Es ist aber auch denkbar, daß die Vergrößerung des Querschnitts nur auf zwei einander gegenüberliegenden Seiten vorhanden ist, um zwar die Kontaktfläche zu vergrößern, aber nur in einer Richtung. Die Vergrößerung der Kontaktfläche führt zu einer verbesserten mechanischen und elektrischen Verbindung.

Bei dem Steckverbinder 5 der Fig. 4 ist am unteren Ende des Schaftes 6 eine quaderförmige Querschnittserweiterung 13 vorgesehen, die ebenfalls zu einer verbesserten Befestigung führt. Auch hier kann vorgesehen sein, die quaderförmige Verbreiterung 13 nur an zwei einander gegenüberliegenden Seiten anzuordnen, so daß ein T entsteht.

Die Fig. 5 zeigt eine Befestigungsmöglichkeit, bei der die mechanische Verbindung zwischen dem Steckverbinder 5 und der Leiterplatte 1 getrennt von der elektrischen Verbindung geschieht. Der Steckverbinder 5 der Ausführungsform nach Fig. 5 steckt in einem Bauelement 14, durch das sein Schaft 6 hindurchgeht. Die Verbreiterung 13 am unteren Ende des Schaftes 6 liegt bündig an der Unterseite 15 des Bauelements 14 an. An der unteren Fläche 16 des Steckverbinders 5 ist ein metallisches Federelement 17 angebracht, das praktisch aus einem zusammengeklappten Stück Blech besteht, dessen beide Schenkel Federeigenschaften aufweisen. Dieses Federelement ist zwischen dem stumpfen Ende des Steckverbinders 5 und dem Lötpad 3 eingesetzt. Es kann, wie erwähnt, beispielsweise an dem Steckverbinder 5 befestigt sein, beispielsweise durch eine Lötung oder auch eine Schweißung.

Die mechanische Verbindung zwischen dem Steckverbinder 5 und der Leiterplatte 1 geschieht dadurch, daß das Bauelement 14 mit Hilfe einer Schraube 18 an der Leiterplatte 1 festgeschraubt wird. Die Schraube 18 greift durch eine Öffnung 19 des Bauelements 14 hindurch in eine Gewindebohrung 20 in der Leiterplatte 1. Natürlich ist in der Regel eine zweite oder auch mehrere Schrauben 18 vorhanden, um das Bauelement 14 an der Leiterplatte 1 anzuschrauben. Statt einer Verbindung durch Schrauben kann auch eine Verbindung durch Niete oder sonstige Verbindungselemente erfolgen. Das Federelement 17 sorgt dafür, daß ein hoher Kontaktdruck aufrechterhalten bleibt.

Der Vorteil der von der Erfindung vorgeschlagenen Befestigungsmöglichkeiten und des Verfahrens liegt darin, daß bei einem großen Pinout nur eine relativ kleine Fläche benötigt wird. Die Befestigung des Steckverbinders, selbstverständlich auch mehrerer Steckverbinder, führt zu einem robusten Gehäuse. Die Gestaltung des Layouts und die Bestückung sind einfach. Bei hoher Signaldichte sind relativ große Raster möglich, vor allem im Vergleich zu der SMD. Die Verbindung weist geringe parasitäre Induktivitäten und bessere Hochfrequenzeigenschaften auf. Der Isolierkörper des Steckverbinders sollte temperaturbeständig sein und kann zur besseren Fixierung und Aufnahme von Steckkräften mit Haltenoppen versehen werden. Die Lötpads 3 werden auch Landepads genannt. Der Werkstoff des Steckverbinders kann zur Verbesserung der Kontakteigenschaften aus SMA bestehen, einer Legierung, die sich in der Z-Achse entsprechend ausdehnt. Ebenfalls möglich ist es, daß die Kontaktfläche des Steckverbinders mit einem zusätzlichen weicheren Material versehen wird, beispielsweise einer Zinn-Legierung, das durch die Anpreßkraft plastisch verformt wird.

In den Figuren wurden Ausführungsformen dargestellt, bei denen das stumpfe Ende des Schafts 6 des Steckverbinders verbreitert ist. Die Erfindung schlägt aber auch vor, Steckverbinder zu verwenden, bei denen die der Leiterplatte 1 zugeordnete Endfläche des Schafts nicht verbreitert ist. Auch eine solche Endfläche kann eine Vertiefung aufweisen oder konkav ausgebildet sein. Sie kann natürlich auch eben sein.

Ebenfalls möglich ist es, den Steckverbinder als Rohr auszubilden oder in seiner Endfläche mit einem Sackloch zu versehen, um die Kapillarwirkung der Lötung auszunutzen.

Der Querschnitt des Steckverbinders braucht nicht viereckig oder quadratisch zu sein, auch runde oder sonstige zylindrische Formen sind möglich.

## Patentansprüche

1. Befestigungsanordnung eines Steckverbinders (5) an einer Leiterplatte (1), mit
1.1 einer Leiterplatte (1),
1.2 einer metallischen Fläche (4) auf der Leiterplatte (1), sowie mit
1.3 einem Steckverbinder (5), der
1.3.1 ein stumpfes Ende (7) aufweist und
1.3.2 mit diesem stumpfen Ende (7) leitend mit der metallischen Fläche (4) verbunden ist.

2. Anordnung nach Anspruch 1, bei der das stumpfe Ende (7) des Steckverbinders (5) mindestens im Randbereich in einer Ebene liegt, die insbesondere senkrecht zur Längsachse des Steckverbinders (5) verläuft.

3. Anordnung nach Anspruch 1 oder 2, bei der das Ende des Steckverbinders (5) mit der Fläche (4) verlötet ist.

4. Anordnung nach einem der vorhergehenden Ansprüche, bei der zum Verlöten eine Lötpaste auf die metallische Fläche (4) und/oder das Ende (7) des Steckverbinders (5) aufgebracht ist.

5. Anordnung nach einem der vorhergehenden Ansprüche, bei der das Ende (7) des Steckverbinders konkav ausgebildet ist.

6. Anordnung nach einem der vorhergehenden Ansprüche, bei der das Ende (7) des Steckverbinders (5) eine Vertiefung (8) zur Aufnahme einer Lötkugel (9) aufweist.

7. Anordnung nach einem der vorhergehenden Ansprüche, bei der die Leiterplatte (1) eine Vertiefung (11) zur Aufnahme einer Lötkugel (9) aufweist.

8. Anordnung nach einem der vorhergehenden Ansprüche, bei der das Ende (7) des Steckverbinders (5) eine vergrößerte Fläche aufweist.

9. Anordnung nach einem der vorhergehenden Ansprüche, bei der die Verbindung eine Verpressung ist.

10. Anordnung nach Anspruch 9, bei der zwischen dem Steckverbinder (5) und der metallischen Fläche (4) eine metallische Feder (17) angeordnet wird.

11. Verfahren zum Anbringen eines Steckverbinders (5) an einer Leiterplatte (1), bei dem
11.1 die Leiterplatte (1) mit einer metallischen Fläche (4) versehen wird, an der der Steckverbinder (5) angebracht werden soll,
11.2 ein Steckverbinder (5) mit einem stumpfen Ende (7) verwendet wird,
11.3 das stumpfe Ende (7) des Steckverbinders (5) mit der metallischen Fläche (4) in Kontakt gebracht und
11.4 leitend mit dieser verbunden wird.

12. Verfahren nach Anspruch 11, bei dem der Steckverbinder (5) mit der metallischen Fläche (4) verlötet wird.

13. Verfahren nach Anspruch 12, bei dem das Ende des Steckverbinders (5) und/oder die metallische Fläche (4) vor dem Verlöten mit einer Lötpaste bestrichen wird.

14. Verfahren nach Anspruch 12 oder 13, bei dem das Ende (7) des Steckverbinders (5) und/oder die Leiterplatte (1) mit einer Vertiefung (8, 11) versehen wird und darin eine Lötkugel (9) angeordnet wird.

15. Verfahren nach einem der Ansprüche 11 bis 14, bei dem ein Steckverbinder (5) mit einer gegenüber dem Schaft (6) des Steckverbinders (5) vergrößerten Fläche verwendet wird.

16. Verfahren nach einem der Ansprüche 11 bis 15, bei dem der Steckverbinder (5) mit der metallischen Fläche (4) verpreßt wird.

17. Verfahren nach Anspruch 15, bei dem zwischen dem Steckverbinder (5) und der Leiterplatte (1) eine metallische Feder (17) angeordnet wird.
